# EUROPEAN PATENT APPLICATION

(11) **EP 2 015 368 A2**
(43) Date of publication of application: **14.01.2009**
(21) Application number: 08252319.2
(22) Date of filing: 07.07.2008
(51) Int. Cl.: H01L 31/04, H01L 31/0232

(54) **Thermophotovoltaic electrical generation systems**

(30) Priority: 09.07.2007 US 825740
(71) Applicant: United Technologies Corporation, Hartford, CT 06101 (US)
(72) Inventor: Radhakrishnan, Rakesh, Vernon Connecticut 06066 (US); Strife, James R., Vernon Connecticut 06066 (US); Walker, Craig R., South Glastonbury Connecticut 06073 (US); Irish, James R., Vernon Connecticut 06066 (US)
(74) Representative: Tomlinson, Kerry John

(57) **Abstract**

A thermophotovoltaic electricity generating system (10) having a heat source (12) generating a thermal emission (14) having a plurality of wavelengths. There is an optical filter (16) filtering the thermal emission into a filtered emission (18). There is also a thermophotovoltaic device (20) receiving the filtered emission. The thermophotovoltaic device is configured to absorb the thermal emission and to convert the thermal emission into electricity. Optionally an optical concentrator (24) produces a concentrated thermal emission (26) directed at the thermophotovoltaic device (20).

## Description

### BACKGROUND OF THE INVENTION

### 1. Field of the Invention

The present disclosure is related to electrical generation systems. More particularly, the present disclosure is related to thermophotovoltaic (TPV) electrical generation systems.

### 2. Description of Related Art

Many vehicles require a primary mover and an electrical generating system. A typical electrical generating system, such as an alternator or generator, has the disadvantage of being a parasitic system wherein the electrical generation system utilizes the primary mover in operation. Consequently, the electrical generation system is a power drain on the primary mover, resulting in an inefficient system.

Due to environmental concerns and the rising costs of fuel, there is an intrinsic desire to operate vehicles as efficiently as possible. Thus, there is a need for an electrical generating system that is non-parasitic. Even better, there is a need for an electrical generating system that can utilize byproducts from the primary mover in operation.

### BRIEF SUMMARY OF THE INVENTION

It is an object of the present invention to provide thermophotovoltaic electricity generating systems.

These and other objects and advantages of the present invention are provided by a thermophotovoltaic electricity generating system having a heat source generating a thermal emission having a plurality of wavelengths. There is an optical filter filtering the thermal emission into a filtered emission. There is also a thermophotovoltaic device receiving the filtered emission. The thermophotovoltaic device is configured to absorb the thermal emission and to convert the thermal emission into electricity.

A method for generating electricity is also provided. The method includes filtering a thermal emission to generate a filtered emission, directing the filtered emission to a thermophotovoltaic device, and operating the thermophotovoltaic device so that the filtered emission is converted into electricity.

The above-described and other features and advantages of the present invention will be appreciated and understood by those skilled in the art from the following detailed description, drawings, and appended claims.

### BRIEF DESCRIPTION OF THE SEVERAL VIEWS OF THE DRAWINGS

FIG. 1 shows an exemplary embodiment of a TPV electrical generation system according to the present disclosure.
FIG. 2 shows an exemplary embodiment of a TPV electrical generation system according to the present disclosure further comprising an optical concentrator.
FIG. 3 shows an exemplary embodiment of a method of generating electricity according to the present disclosure.

### DETAILED DESCRIPTION OF THE EMBODIMENTS

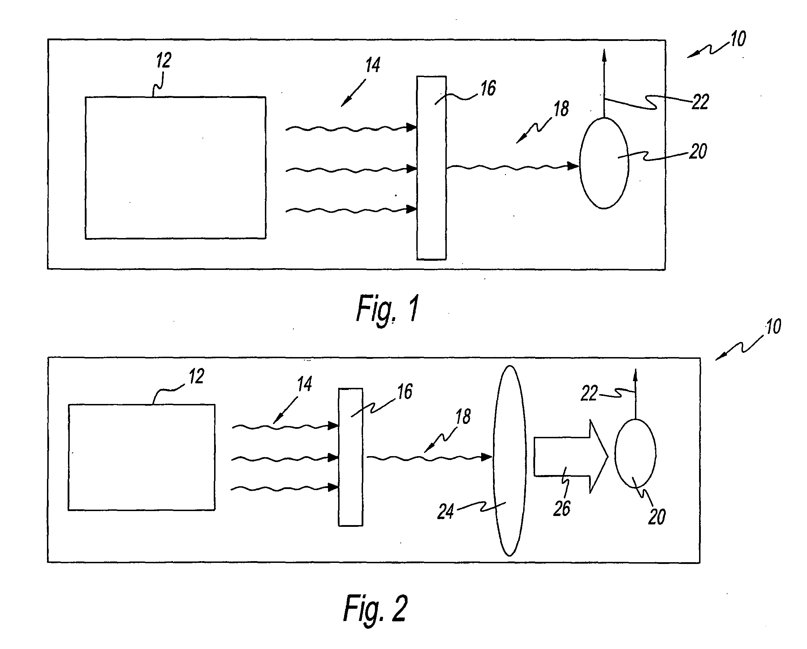

Referring to the drawings and in particular to FIG. 1, an exemplary embodiment of a thermophotovoltaic (TPV) electrical generation system 10 according to the present disclosure is shown. Advantageously, system 10 converts radiant heat energy into electricity and since system 10 has few moving parts, the system is relatively quiet and requires low maintenance.

System 10 includes a heat source 12, an optical filter 16, and a thermophotovoltaic device 20.

Thermophotovoltaic (TPV) device 20 can be any device capable of generating electricity from the heat radiated from heat source 12. For example, TPV device 20 can be a photovoltaic diode cell that generates electricity when exposed to radiant heat of one or more particular wavelengths. In this manner, the photovoltaic diode absorbs radiation of the one or more particular wavelengths and converts the radiated photons into electricity.

For purposes of discussion, heat source 12 is described herein as a jet engine of a vehicle such as an airplane (not shown). However, it is contemplated by the present disclosure for system 10 to find use in various applications in a wide array of industries, including nuclear operations, coal operations, internal combustion engines, waste heat from petrochemical, cement, agro and other industrial sources and with a wide array of heat sources 12.

In use, heat source 12 generates a thermal emission 14. Thermal emission 14 comprises radiant heat emissions having a plurality of varying wavelengths. Thus, it has been determined by the present disclosure that much of the energy within thermal emission 14 is simply not useable by TPV device 20 for generating electricity. Further, it has also been determined by the present disclosure that, in some instances, the plurality of wavelengths of thermal emission 14 can interfere with the particular wavelength or wavelengths that is/are useable by TPV device 20.

Accordingly, system 10 includes optical filter 16 positioned between heat source 12 and TPV device 20 so that thermal emission 14 flows through the optical filter to form filtered emission 18.

Advantageously, optical filter 16 is selected so that most, and preferably all, of the wavelengths of thermal emission 14 that interfere with the operation of TPV device 20 have been removed from filtered emission 18. Further, optical filter 16 is, in some embodiments, selected so that the resultant filtered emission is matched to the useable wavelength or wavelengths of TPV device 20.

In some embodiments, optical filter 16 is a type of photonic crystal that can convert a broad wavelength of thermal emission 14 into one or a plurality of sharp wavelengths of filtered emission 1.8. It is contemplated by the present disclosure that optical filter 16 can be composed of any known type of material suitable for filtering thermal emission 14, including but not limited to, bulk crystals, quantum dots, nanoparticles comprised of typical semiconductor materials such as silicon, germanium, and gallium arsenide, and any combinations thereof. It is also contemplated herein that optical filter 16 can comprise mixed metal oxides, including but not limited to, titanium dioxide, zirconium oxide, cerium oxide, or combinations thereof. The filtering capacity of optical filter 16 may be generated utilizing structural and morphological changes.

TPV device 20 absorbs and converts filtered emission 18 into electricity 22 in a known manner. Accordingly, system 10, due to the incorporation of optical filter 16 in the energy path between heat source 12 and TPV device 20, ensures that the TPV device is exposed to filtered emission 18, which minimizes wavelengths that negatively affect the performance of the TPV device while maximizing the wavelength and/or wavelengths that are useable by the TPV device for the generation of electricity 22. As such, system 10 maximizes the efficiency of TPV device 20.

Referring now to FIG. 2, system 10 is shown having an optical concentrator 24 between optical filter 16 and TPV device 20 so that filtered emission 18 leaving the optical filter 16 passes through the optical concentrator. Optical concentrator 24 enhances the intensity of filtered emission 18 impinging on TPV device 20 so as to enhance the amount of electrons that are generated and collected. As filtered emission 18 passes through optical concentrator 24, it is concentrated into a concentrated thermal emission 26 and directed to TPV device 20. Concentrated thermal emission 26 is then absorbed by TPV device 20 and converted into electricity 22.

In FIG. 2, optical concentrator 24 is positioned after optical filter 16 and before TPV device 20. It should be recognized, however, that optical concentrator 24 may be placed anywhere in the path of energy radiating from heat source 12.

Additionally, optical concentrator 24 is shown in FIG. 2 as a separate component of system 10. However, it is also contemplated for optical concentrator 24 to be integral with optical filter 16. For example, optical filter 16 can be coated so as to form optical concentrator 24 on the optical filter.

Advantageously, system 10 may be used for low temperature heat sources, e.g. sources emitting thermal emission 14 at temperatures of less than 500 degrees Celsius, because none of the materials will undergo significant degradation. It is contemplated herein that system 10 may be used in conjunction with industrial waste heat, stationary or mobile internal combustion engines, and stationary or mobile turbine engines.

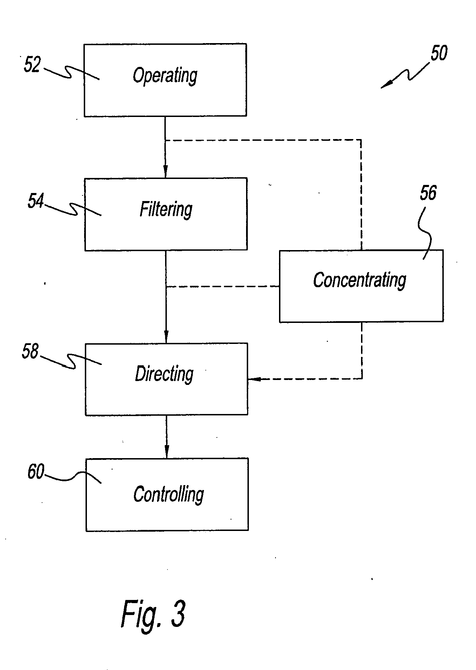

Referring now to FIG. 3, an exemplary embodiment of a method according to the present disclosure of generating electricity is generally illustrated as reference numeral 50. Advantageously, method 50 converts thermal emissions 14 from heat source 12 into electricity 22.

Method 50 includes an operating step 52, a filtering step 54, a directing step 58, and a controlling step 60. During operating step 52, heat source 12 is running and generating thermal emission 14. Thermal emission 14 then passes through optical filter 16 in filtering step 54 and thermal emission 14 is converted into filtered emission 18. During directing step 58, filtered emission 18 exiting optical filter 16 is directed onto TPV device 20. During controlling step 60, TPV device 20 is optionally turned either on or off such that the TPV device 20 can selectively convert filtered emission 18 into electricity as desired.

It is also contemplated herein that method 50 may include concentrating step 56. As discussed above with respect to FIG. 2, concentrating step 56 may occur before, during, or after filtering step 54. During concentrating step 56, optical concentrator 24 generates concentrated emission 26 and directs the concentrated emission towards TPV device 20.

While the present disclosure has been described with reference to one or more exemplary embodiments, it will be understood by those skilled in the art that various changes may be made and equivalents may be substituted for elements thereof without departing from the scope of the present disclosure. In addition, many modifications may be made to adapt a particular situation or material to the teachings of the disclosure without departing from the scope thereof. Therefore, it is intended that the present disclosure not be limited to the particular embodiment(s) disclosed as the best mode contemplated, but that the invention extends to all embodiments falling within the scope of the appended claims and their equivalents.

## Claims

1. A thermophotovoltaic electricity generating system (10), comprising:
a heat source (12) generating a thermal emission (14) having a plurality of wavelengths;
an optical filter (16) filtering the thermal emission into a filtered emission (18); and a thermophotovoltaic device (20) receiving the filtered emission, the thermovoltaic device being configured to absorb the thermal emission and to convert the thermal emission into electricity.

2. The system of claim 1, wherein the heat source (12) is a jet engine.

3. The system of claim 1 or 2, wherein the optical filter (16) comprises a photonic crystal.

4. The system of claim 1 or 2, wherein the optical filter (16) comprises a material selected from the group consisting of a bulk crystal, a quantum dot, a nanoparticle, and any combinations thereof.

5. The system of claim 1, 2, 3 or 4, further comprising an optical concentrator (24) for directing a concentrated thermal emission (26) onto the thermophotovoltaic device (20).

6. The system of claim 5, wherein the optical concentrator (24) is before or after, in a direction of the thermal emission, the optical filter (16).

7. The system of claim 5, wherein the optical filter (16) and the optical concentrator (24) comprise a unitary filter concentrator.

8. A method of generating electricity, comprising:
filtering a thermal emission to generate a filtered emission; directing the filtered emission to a thermophotovoltaic device; and operating the thermophotovoltaic device so that the filtered emission is converted into electricity.

9. The method according to claim 8, further comprising concentrating the thermal emission.

10. The method according to claim 9, wherein the concentrating step comprises concentrating the thermal emission before or after the filtering step.

11. The method according to claim 9, wherein the concentrating step comprises concentrating and filtering the thermal emission in a single device.
